# EUROPÄISCHE PATENTSCHRIFT

(11) **EP 1 103 051 B1**
(45) Veröffentlichungstag und Bekanntmachung des Hinweises auf die Patenterteilung: **23.04.2003**
(21) Anmeldenummer: 99945910.0
(22) Anmeldetag: 05.07.1999
(51) Int. Cl.: G11C 11/22

(54) **FERROELEKTRISCHE SPEICHERANORDNUNG**
FERROELECTRIC STORAGE ASSEMBLY
ENSEMBLE MEMOIRE FERRO LECTRIQUE

(30) Priorität: 22.07.1998 DE 19832994
(43) Veröffentlichungstag der Anmeldung: 30.05.2001
(73) Patentinhaber: Infineon Technologies AG, 81669 München (DE)
(72) Erfinder: BRAUN, Georg, D-80339 München (DE); HÖNIGSCHMID, Heinz, D-82319 Starnberg (DE)
(74) Vertreter: Kottmann, Heinz Dieter, Dipl.-Ing.
(86) Internationale Anmeldenummer: DE9902071
(87) Internationale Veröffentlichungsnummer: WO00005720

(56) Entgegenhaltungen:
- WO-A-99/14761
- US-A- 5 224 069
- US-A- 5 455 786

## Beschreibung

Die vorliegende Erfindung betrifft eine ferroelektrische Speicheranordnung mit einem Speicherzellenfeld aus einer Vielzahl von Speicherzellen, die jeweils wenigstens einen Auswahltransistor und einen Speicherkondensator aufweisen und über Wortleitungen und Bitleitungen ansteuerbar sind, wobei jeder Kurzschlusstransistor mit seiner steuerbaren Strecke zwischen den Elektroden des zugehörigen Speicherkondensators angeordnet ist.

Eine derartige ferroelektrische Speicheranordnung ist beispielsweise aus der US 5,224,069 bekannt: Hier ist eine Reihenschaltung aus zwei MOS-Transistoren mit einer Bitleitung verbunden. Jeder der beiden MOS-Transistoren ist über jeweils eine Wortleitung ansteuerbar. Der Knoten zwischen den beiden MOS-Transistoren ist an die eine Elektrode eines Speicherkondensators angeschlossen, dessen andere Elektrode mit einer Taktleitung und Drain des von der Bitleitung abgewandten zweiten MOS-Transistors der Reihenschaltung verbunden ist.

Die Nichtflüchtigkeit ferroelektrischer Speicheranordnungen beruht bekanntlich auf einem ferroelektrischen Effekt, bei dem die Polarisation von Dipolen innerhalb eines Isolators trotz eines fehlenden äußeren elektrischen Feldes beibehalten wird. Mit anderen Worten, die Beibehaltung der gespeicherten Information bedingt gerade, daß kein elektrisches Feld an einen Speicherkondensator der Speicheranordnung angelegt werden darf.

In integrierten Schaltungen läßt sich aber nicht vermeiden, daß speziell durch parasitäre Bauelemente kleine Spannungsdifferenzen an den Elektroden von ferroelektrischen Speicherkondensatoren auftreten. Je nach der Polarisation des Dielektrikums des Speicherkondensators und nach der Polarität der Spannungsdifferenzen verstärken diese die Polarisation des Dielektrikums oder schwächen sie.

Die Spannungsdifferenzen können auch als Störimpulse bezeichnet werden. Abhängig von der Anzahl und/oder der Amplitude der Störimpulse wird so die gespeicherte Information mehr oder weniger stark geschwächt. Im schlimmsten Fall kann es beim Lesen der Speicheranordnung sogar zu einer Fehlbewertung kommen, was praktisch einem Datenverlust entspricht.

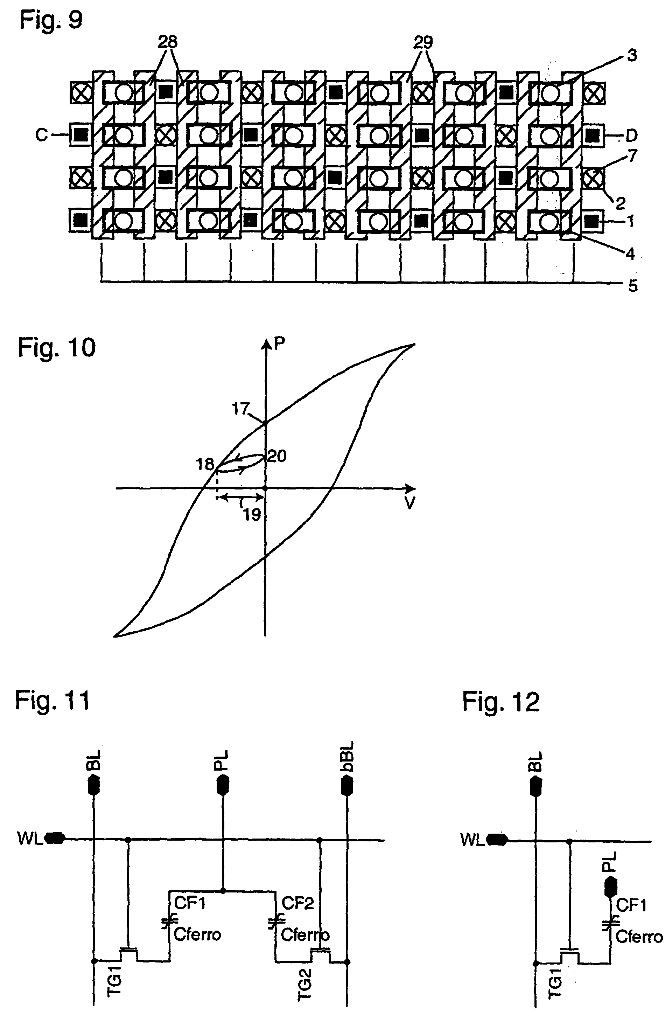

Dies soll im folgenden anhand der Fig. 10 näher erläutert werden, in welcher die Hysteresekurve eines ferroelektrischen Speicherkondensators aufgetragen ist. Diese Hysteresekurve zeigt, daß es bei einer anliegenden Spannung V = 0 zwei Polarisationszustände P gibt, welche Information speichern können. Wandert beispielsweise infolge eines Störimpulses 19 die Polarisation von einem Punkt 17 zu einem Punkt 18 und liegt nach Abklingen des Störimpulses wieder die Spannung 0 an, so geht die Polarisation nicht zu dem Punkt 17 zurück, sondern wandert vielmehr zu einem Punkt 20, der unterhalb des Punktes 17 gelegen ist. Mehrere Störimpulse können so bewirken, daß schließlich die Information verlorengeht.

Das Einkoppeln von Störimpulsen während des Betriebes einer Speicheranordnung hängt auch davon ab, welches Konzept für die Speicheranordnung angewandt wird.

Beim sogenannten VDD/2-Konzept führen insbesondere das kapazitive Einkoppeln von Spannungsschwankungen an einer gemeinsamen Elektrode aller ferroelektrischen Speicherkondensatoren, beispielsweise beim Ein- und Ausschalten der Speicheranordnung, und ein Leckstrom gesperrter PN-Übergänge zu Störimpulsen.

Beim Pulskonzept bedingt speziell kapazitives Überkoppeln einer gepulsten Elektrodenschiene auf nicht-selektierte Speicherzellen Störimpulse.

Weiterhin bedingen beim VDD/2- und Pulskonzept Ladungsinjektion und kapazititves Einkoppeln des Auswahltransistors bzw. Transfergates Störimpulse.

Schließlich verursacht beim NAND-Konzept der Spannungsabfall an den Transistoren durch den Stromfluß, der beim Lesen und Schreiben einer Speicherzelle auftritt, Störimpulse.

Für das Leckstromproblem beim VDD/2-Konzept gibt es zwei Lösungsansätze: beide beruhen darauf, daß die Ladung, die durch den gesperrten PN-Übergang abfließt, entweder ständig oder zyklisch durch den Auswahltransistor der Speicherzelle nachgeliefert wird. Ein ständiges Einschalten der Auswahltransistoren ist aber nur solange möglich, als auf die Speicheranordnung nicht zugegriffen wird. Erfolgt nämlich ein Zugriff auf die Speicheranordnung, so darf nur eine Wortleitung des Speicherzellenfeldes aktiv sein, während alle anderen Wortleitungen abgeschaltet werden müssen. Nach dem Speicherzugriff müssen sodann alle Wortleitungen wieder eingeschaltet werden, was durch die hohe kapazitive Last einen großen Anstieg des Leistungsbedarfs bewirkt. Auch hat das zyklische Einschalten der Auswahltransistoren den Nachteil, daß durch den Leckstrom zwischen den Zyklen Störimpulse an den Speicherkondensatoren auftreten, die sich allenfalls in ihrer Amplitude begrenzen lassen. Erschwerend kommt hinzu, daß der Leckstrom eines gesperrten PN-Übergangs nicht nur starken Schwankungen unterliegt, sondern auch mit der Temperatur beträchtlich ansteigt.

Beim Pulskonzept werden, um Chipfläche einzusparen und die Speicheranordnung möglichst klein zu gestalten, meist doppelt so viele Speicherkondensatoren an eine gemeinsame Elektrodenschiene angeschlossen, als bei einem Lese- und Schreibzugriff angesprochen werden. Um dies zu umgehen, müßte somit die Grundfläche einer Speicherzelle deutlich vergrößert werden, was jedoch aus Kostengründen nicht anzustreben ist.

Bei einer NAND-ähnlichen Anordnung der Speicherzellen, die sich auch in Kombination mit dem VDD/2-Konzept einsetzen läßt, wird das Leckstromproblem gesperrter PN-Übergänge gelöst. Allerdings treten dann durch den endlichen Widerstand der Transistoren beim Lesen oder Schreiben der Speicherzellen Störimpulse an den Nachbarzellen auf.

Für das beim VDD/2- und Pulskonzept auftretende Problem der Ladungsinjektion und des kapazitiven Einkoppelns der Auswahltransistoren gibt es derzeit noch keine befriedigende Lösung. Allerdings dürfte dieses Problem in Zukunft weniger Schwierigkeiten bereiten, da die Kanalladung von Feldeffekttransistoren mit zunehmender Integrationsdichte immer weiter abnimmt.

Fig. 11 zeigt noch eine bestehende Zwei-Transistor-Zwei-Kondensator-Speicherzelle (2T2C-Speicherzelle), bei der Information komplementär gespeichert wird, was den Vorteil hat, daß keine Referenzzelle benötigt wird.

In Fig. 12 ist eine Ein-Transistor-Ein-Kondensator-Speicherzelle (1T1C-Speicherzelle) gezeigt. Diese Speicherzelle kann sowohl für eine "offene" Bitleitungsanordnung als auch für eine "gefaltete" Bitleitungsanordnung verwendet werden. In beiden Fällen ist für die Bewertung eines Lesesignals eine Referenzspannung notwendig.

Sowohl die 2T2C-Speicherzelle als auch die 1T1C-Speicherzelle sind für das VDD/2-Konzept als auch für das Pulskonzept geeignet.

Im einzelnen zeigen die Fig. 11 und 12 Wortleitungen WL, Bitleitungen BL bzw. bBL, eine Versorgungsleitung PL, ferroelektrische Speicherkondensatoren CF1 und CF2 mit einer Kapazität Cferro und Auswahlttransistoren TG1, TG2.

Bei allen Speicheranordnungen, die derartige Speicherzellen verwenden, treten unabhängig davon, welches Konzept der Speicheranordnung zugrundeliegt, die oben genannten Probleme infolge von Störimpulsen auf.

Es ist daher Aufgabe der vorliegenden Erfindung, eine ferroelektrische Speicheranordnung zu schaffen, bei der durch Störimpulse verursachte Informationsverluste zuverlässig vermieden sind.

Zur Lösung dieser Aufgabe zeichnet sich eine ferroelektrische Speicheranordnung der eingangs genannten Art erfindungsgemäß dadurch aus, daß die Kurzschlußtransistoren eine andere Einsatzspannung als die Auswahltransistoren haben und Steueranschlüsse der Auswahltransistoren und Steueranschlüsse der Kurzschlußtransistoren mit den Wortleitungen verbunden sind.

Um nachteilhafte Einflüsse der Störimpulse zu vermeiden, wird also bei der erfindungsgemäßen Speicheranordnung für jeden ferroelektrischen Speicherkondensator ein zusätzlicher Transistor vorgesehen, der die Elektroden des ferroelektrischen Speicherkondensators kurzzuschließen vermag. Dieser zusätzliche Transistor kann entweder vom gleichen Typ wie der Auswahltransistor, also beispielsweise ein Transistor vom Anreicherungstyp mit positiver Einsatzspannung bei N-Kanal-Feldeffekttransistoren oder aber auch in bevorzugter Weise ein Transistor vom Verarmungstyp mit negativer Einsatzspannung bei N-Kanal-Feldeffekttransistoren sein. Ein Transistor vom Verarmungstyp ist besonders vorteilhaft, da durch ihn ein wirkungsvoller Schutz für den ferroelektrischen Speicherkondensator sowohl im aktiven Betriebszustand als auch im abgeschalteten Zustand in der Form eines Faraday Käfigs bereitgestellt wird.

Bei geschickter Wahl der Einsatzspannung kann außerdem sichergestellt werden, daß die Speicheranordnung keine zusätzliche Fläche im Vergleich zu einer 1T1C-Speicherzelle benötigt.

Der Speicherkondensator kann als Stapelkondensator oberhalb des Auswahltransistors oder versetzt als "Offset"-Kondensator neben dem Auswahltransistor angeordnet sein.

Ein Verfahren zum Betreiben der ferroelektrischen Speicheranordnung zeichnet sich dadurch aus, daß nach einem Leseoder Schreibvorgang beide Elektroden des Speicherkondensators durch Ansteuerung über den Kurzschlußtransistor auf gleiches Potential gebracht werden.

Nachfolgend wird die Erfindung anhand der Zeichnungen näher erläutert. Es zeigen:

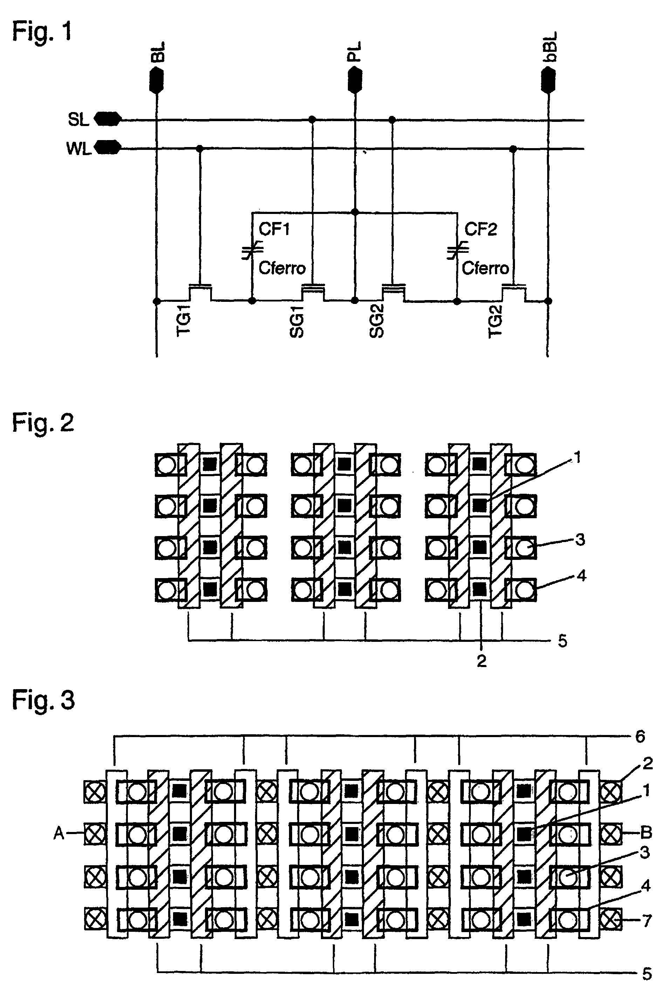

- Fig. 1: ein Schaltbild einer ferroelektrischen Speicheranordnung mit einer 2T2C-Zelle mit Kurzschlußtransistoren nach einem ersten Ausführungsbeispiel der Erfindung,
- Fig. 2: eine schematische Draufsicht auf eine 2T2C-Zelle mit 12 F² und gefalteter Bitleitung,
- Fig. 3: eine schematische Draufsicht auf eine 2T2C-Zelle mit 16 F², Kurzschlußtransistoren und gefalteter Bitleitung,

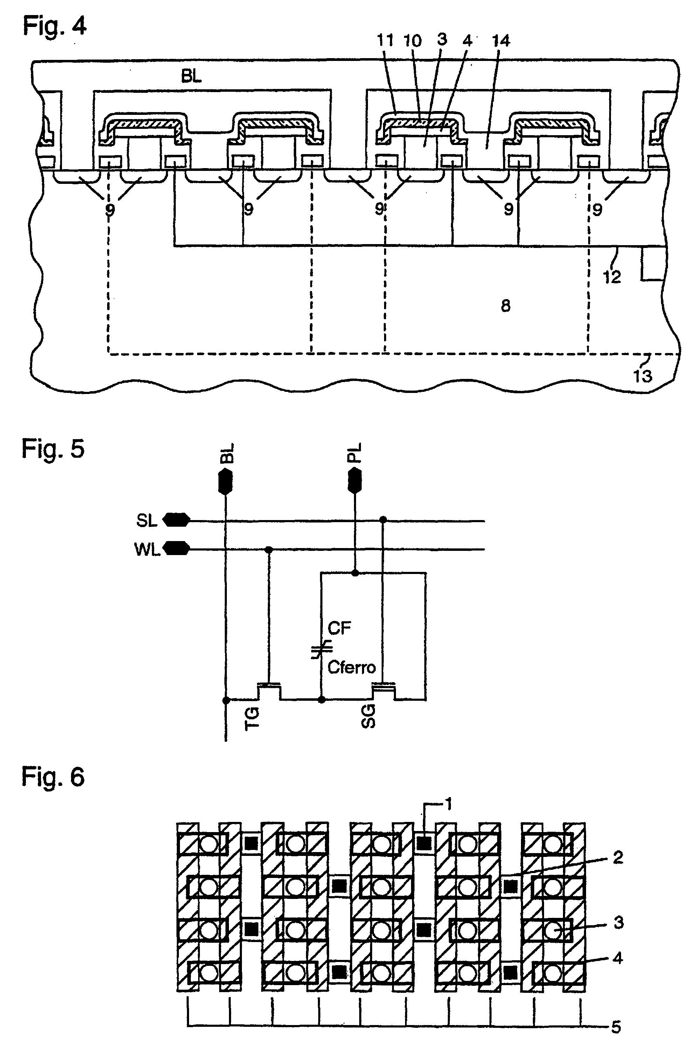

- Fig. 4: eine Schnittdarstellung für die Zelle von Fig. 3 bzw. 9,
- Fig. 5: ein Schaltbild einer ferroelektrischen Speicheranordnung mit einer 1T1C-Zelle mit einem Kurzschlußtransistor nach einem zweiten Ausführungsbeispiel der Erfindung,
- Fig. 6: eine Draufsicht auf eine 1T1C-Zelle mit gefalteter Bitleitung,

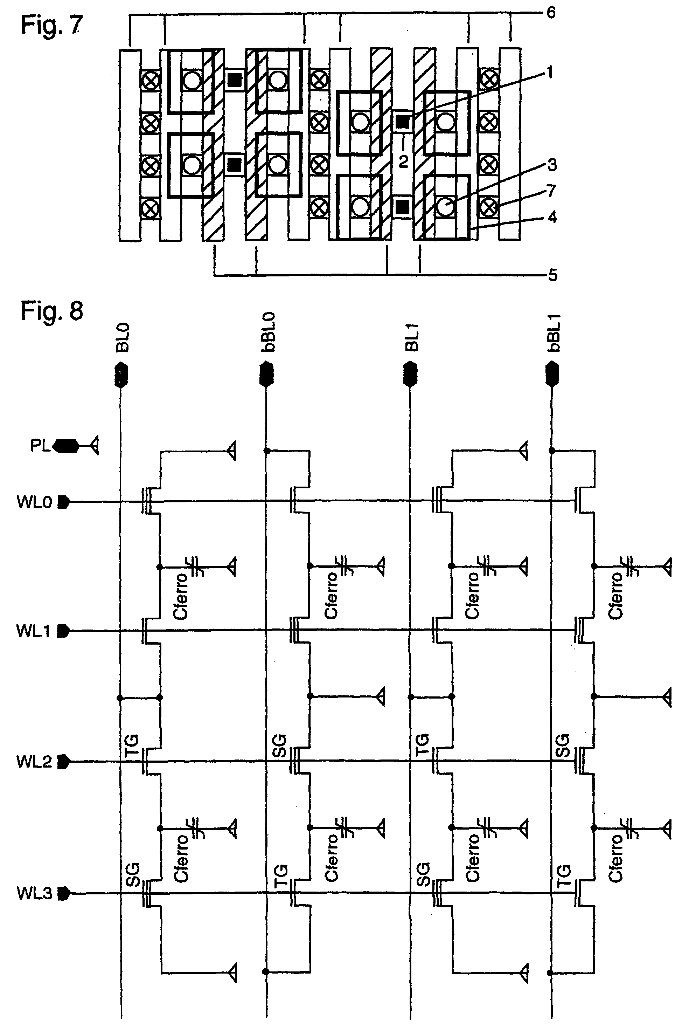

- Fig. 7: eine schematische Draufsicht auf eine 1T1C-Zelle mit 16 F², Kurzschlußtransistor und gefalteter Bitleitung,
- Fig. 8: eine Speicheranordnung mit 1T1C-Zellen mit 8 F², Kurzschlußtransistoren und gefalteter Bitleitungsarchitektur,
- Fig. 9: eine schematische Draufsicht auf 1T1C-Zellen mit 8 F², Kurzschlußtransistoren und gefalteter Bitleitung,
- Fig. 10: eine Hysteresekurve bei einem ferroelektrischen Speicher,
- Fig. 11: ein Schaltbild einer bestehenden 2T2C-Zelle und
- Fig. 12: ein Schaltbild einer bestehenden 1T1C-Zelle.

Die Fig. 10 bis 12 sind bereits eingangs erläutert worden. Im folgenden werden bei der Beschreibung der Fig. 1 bis 9 für einander entsprechende Bauteile die gleichen Bezugszeichen wie in den Fig. 10 bis 12 verwendet.

Fig. 1 zeigt eine Speicherzelle der erfindungsgemäßen ferroelektrischen Speicheranordnung gemäß einem ersten Ausführungsbeispiel der vorliegenden Erfindung. Diese Speicherzelle hat zusätzlich zu der bestehenden Speicherzelle von Fig. 11 noch Kurzschlußtransistoren SG1, SG2, die mit ihren Source-Drain-Strecken jeweils die Speicherkondensatoren CF1, CF2 überbrücken und über eine Steuerleitung SL ansteuerbar sind. Die Kurzschlußtransistoren SG1, SG2 können vom Anreicherungstyp oder vom Verarmungstyp sein, wobei aber der Verarmungstyp bevorzugt wird, da dieser einen wirkungsvollen Schutz für den ferroelektrischen Kondensator CF1 bzw. CF2 sowohl im aktiven Betriebszustand als auch im abgeschalteten Zustand als "Faraday"-Käfig sicherstellt.

Fig. 2 zeigt eine Draufsicht auf eine 2T2C-Speicherzelle mit gefalteter Bitleitung, wobei speziell Bitleitungskontakte 1, eine aktive Fläche 2, ein Plug bzw. Stöpsel 3 zur Durchkontaktierung, eine Bodenelektrode 4 und Wortleitungen 5 dargestellt sind. Die bei dieser Speicherzelle benötigte Zellfläche ergibt sich zu 12 F², wenn der Kontakt zu einer Bitleitung wie bei dynamischen Speichern für zwei benachbarte Transfergates benutzt wird. "F" bedeutet dabei die Abkürzung für "Feature Size" und stellt die kleinste auflösbare Strukturgröße des jeweiligen Prozesses dar.

Die Fig. 2, 3, 6, 7 und 9 zeigen jeweils zueinander ähnliche Speicheranordnungen, wobei in diesen Figuren zur besseren Übersichtlichkeit die Bitleitungen weggelassen sind. Diese Bitleitungen verlaufen in den genannten Figuren in horizontaler Richtung von Bitleitungskontakt 1 zu Bitleitungskontakt 1 entweder über den als Rechtecke gezeichneten Bitleitungskontakten, die die untere Elektrode darstellen, so daß der Kondensator unter der Bitleitung angeordnet ist, oder etwas in vertikaler Richtung versetzt, was die Anordnung eines Kondensators unter der Bitleitung als auch eines Kondensators über der Bitleitung ermöglicht.

Im einzelnen sind in der Fig. 3, die 2T2C-Zellen zeigt, zusätzlich noch Kurzschlußleitungen 6, und ein Plattenkontakt 7 gezeigt. Wie bereits erwähnt, stellt Fig. 6 eine 1T1C-Zelle mit gefalteter Bitleitung und einem Flächenbedarf von 8 F² und Fig. 7 eine 1T1C-Speicherzelle mit Kurzschlußtransistor und gefalteter Bitleitung sowie einem Flächenbedarf von 16 F² dar. Fig. 9 zeigt schließlich eine 1T1C-Zelle mit Kurzschlußtransistor und gefalteter Bitleitung sowie einem Flächenbedarf von 8 F², wobei hier Feldeffekttransistoren 28 vom Anreicherungstyp und Feldeffekttransistoren 29 vom Verarmungstyp verwendet werden.

Mit der Einführung der beiden Kurzschlußtransistoren SG1 und SG2 ist ein zusätzlicher Kontakt von diesen Transistoren zur gemeinsamen Elektrode PL notwendig. Dieser Kontakt kann ebenfalls von den Kurzschlußtransistoren zweier benachbarter Speicherzellen gemeinsam genutzt werden. Eine entsprechende Anordnung ist in Fig. 3 gezeigt, wobei sich hier durch die doppelte Ausnutzung des gemeinsamen Kontaktes die Zellenfläche lediglich von 12 F² auf 16 F² erhöht.

Fig. 4 zeigt eine Schnittdarstellung durch die 2T2C-Speicherzelle mit Kurzschlußtransistoren von Fig. 3, wobei in dieser Figur der Speicherkondensator unter der Bitleitung BL gelegen ist. Außerdem sind in Fig. 4 noch ein Halbleiterkörper 8, der aus beispielsweise p-leitendem Silizium besteht, n⁺-leitende Zonen 9, ein ferroelektrisches Dielektrikum 10 aus beispielsweise SBT (Strontiumwismuthtantalat) oder PZT (Bleizirkoniumtitanat), eine obere Elektrode 11 und schematisch in Vollinien Leitungen 12, die beim Ausführungsbeispiel von Fig. 3 Kurzschlußleitungen und beim Ausführungsbeispiel von Fig. 9 Wortleitungen vom Verarmungstyp sind, sowie bei beiden Ausführungsbeispielen der Fig. 3 und 9 Wortleitungen 13 vom Anreicherungstyp gezeigt. Die Fig. 4 stellt dabei grundsätzlich einen Schnitt A/B durch Fig. 3 bzw. einen Schnitt C/D durch Fig. 9 dar. Schließlich ist aus der Fig. 4 noch ein Plattenkontakt 14 für die gemeinsame Elektrode zu ersehen.

Für die Herstellung der Plattenkontakte 14 kann folgender Prozeßablauf angewandt werden:

Nach dem Abscheiden des ferroelektrischen Dielektrikums 10 werden Löcher für die Plattenkontakte 14 geätzt. Erst anschließend werden entsprechende Plattenleitungen abgeschieden und strukturiert. Dadurch kann ein separates Auffüllen der Plattenleitungs-Kontaktlöcher in einem zusätzlichen Prozeßschritt vermieden werden, sofern der Abscheideprozeß für die Plattenleitung auch für das Auffüllen der Kontaktlöcher geeignet ist.

Fig. 5 zeigt ein Schaltbild einer 1T1C-Speicherzelle mit einem Kurzschlußtransistor SG. Für diesen Kurzschlußtransistor SG kann wiederum ein Feldeffekttransistor vom Anreicherungstyp oder vom Verarmungstyp verwendet werden. Der Kurzschlußtransistor SG überbrückt mit seiner Source-Drain-Strecke wiederum beide Elektroden eines ferroelektrischen Speicherkondensators CF und ist mit seinem Gate an eine Steuerleitung SL angeschlossen.

Die Fig. 6 und 7, auf die bereits oben eingegangen wurde, zeigen Draufsichten einer 1T1C-Speicherzelle mit gefalteter Bitleitung bzw. einer 1T1C-Speicherzelle mit Kurzschlußtransistor und gefalteter Bitleitung. Aus diesen Figuren ist zu ersehen, daß der Flächenbedarf bei der 1T1C-Speicherzelle mit Kurzschlußtransistor um einen Faktor 2 auf 16 F² im Vergleich zu dem Flächenbedarf der 1T1C-Speicherzelle mit einer Fläche von 8 F² angestiegen ist.

Dieser große Flächenbedarf der 1T1C-Speicherzel mit Kurzschlußtransistor gemäß Fig. 7 kann aber drastisch reduziert werden, wenn für den Kurzschlußtransistor SG ein Feldeffekttransistor mit anderer Einsatzspannung als der Auswahltransistor oder ein Feldeffekttransistor vom Verarmungstyp verwendet wird. Neben den bereits erwähnten Vorteilen des "Faraday"-Käfigs beim Feldeffekttransistor vom Verarmungstyp für den ferroelektrischen Kondensator besteht dann nämlich die Möglichkeit, die Funktion der Wortleitung und der Steuerleitung SL auf einer Leitung zu vereinen. Eine entsprechende Speicherzellenanordnung mit 1T1C-Speicherzellen mit Kurzschlußtransistoren und einem Flächenbedarf von 8 F² ist schematisch in Fig. 8 mit Wortleitungen WL0, WL1, WL2, WL3 und Bitleitungen BL0, bBL0, BL1 und bBL1, Auswahltransistoren TG und Kurzschlußtransistoren SG sowie Speicherkapazitäten Cferro gezeigt. Die Speicherzellen sind dabei so miteinander verbunden, daß an der als Wortleitung und als Steuerleitung dienenden Leitung sowohl Auswahltransistoren TG als auch Kurzschlußtransistoren SG angeschlossen sind. Die Auswahltransistoren TG und die Kurzschlußtransistoren SG sind dabei abwechselnd an diese Leitung angeschlossen.

Aus der Draufsicht von Fig. 9 ist zu ersehen, daß der Flächenbedarf für eine solche 1T1C-Speicherzelle mit Kurzschlußtransistoren lediglich 8 F² beträgt. Eine Schnittdarstellung C/D der Speicherzellen von Fig. 9 ist wieder durch die Fig. 4 gegeben.

Im folgenden soll anhand der Fig. 8 die Funktionsweise der erfindungsgemäßen ferroelektrischen Speicheranordnung für N-Kanal-Feldeffekttransistoren erläutert werden. Dabei wird vorausgesetzt, daß die Einsatzspannung der Feldeffekttransistoren vom Verarmungstyp negativer ist als der negative Wert der Spannung an der gemeinsamen Elektrode PL.

Wird die Speicheranordnung eingeschaltet, so befinden sich alle Wortleitungen WL auf 0 V. Zuerst wird sodann die gemeinsame Elektrode PL von 0 V auf die Spannung VDD/2 hochgefahren. Da nun die Einsatzspannung der Feldeffekttransistoren vom Verarmungstyp entsprechend stark negativ gewählt ist, leiten diese Feldeffekttransistoren auch dann noch, nachdem die gemeinsame Elektrode auf VDD/2 aufgeladen wurde. Damit sind alle Elektroden der ferroelektrischen Speicherkondensatoren kurzgeschlossen.

Um nun auf bestimmte Speicherzellen zugreifen zu können, wird die entsprechende Wortleitung, also beispielsweise die Wortleitung WL2 von 0 V auf die volle Versorgungsspannung VDD oder höher aufgeladen, wodurch die gewünschten ferroelektrischen Kondensatoren mit den entsprechenden Bitleitungen BL verbunden werden. Befinden sich diese Bitleitungen auf einem Potential, das größer oder kleiner als das Potential der gemeinsamen Elektrode PL ist, vollzieht sich ein Ladungsausgleich zwischen den selektierten ferroelektrischen Kondensatoren und den zugehörigen Bitleitungen BL. Bevor dies aber eintritt, müssen jedoch die Kurzschlußgates, die die selektierten Kondensatoren kurzschließen, abgeschaltet werden. Dies geschieht durch ein negatives Potential an der entsprechenden Wortleitung, also beispielsweise an der Wortleitung WL3. Durch dieses negative Potential werden lediglich die gewünschten Feldeffekttransistoren vom Verarmungstyp abgeschaltet.

Die Feldeffekttransistoren vom Anreicherungstyp, die ebenfalls mit der Wortleitung WL3 verbunden sind, waren bereits durch das Bereitschaftspotential von 0 V abgeschaltet und werden durch das negative Potential nur noch hochohmiger gemacht.

Nach Bewerten des Lesesignales und dessen Verstärken wird schließlich die selektierte Wortleitung, beispielsweise die Wortleitung WL2, wieder auf 0 V entladen, was die selektierten Speicherzellen wieder von den Bitleitungen abtrennt. Um den Kurzschluß der Elektroden mit den selektierten Speicherzellen wieder herzustellen, wird die Wortleitung, die mit dem entsprechenden Feldeffekttransistor vom Verarmungstyp verbunden ist, also im vorliegenden Beispiel die Wortleitung WL3, wieder auf 0 V zurückgebracht.

Eine andere Möglichkeit besteht darin, beispielsweise zuerst die Spannung an der gemeinsamen Elektrode auf den Bitleitungen einzustellen, und sodann die Kurzschluß-Gates einzuschalten, indem die Wortleitung WL3 auf 0 V gebracht wird. Schließlich wird sodann die Wortleitung WL2 auf 0 V entladen, um die selektierten Speicherzellen wieder von den Bitleitungen zu trennen.

Ein wesentlicher Vorteil der erfindungsgemäßen ferroelektrischen Speicheranordnung mit Kurzschlußtransistoren liegt darin, daß ohne zusätzlichen Platzbedarf im Speicherzellenfeld die Ursachen für Störimpulse zuverlässig zu vermeiden sind. Zusätzlich stellt der Feldeffekttransistor vom Verarmungstyp einen idealen Schutz für den ferroelektrischen Kondensator in dessen abgeschaltetem Zustand dar.

Ein weiterer Vorteil der Verwendung von Feldeffekttransistoren vom Verarmungstyp liegt darin, daß eine alterungsbedingte Verschiebung der Hysteresekurve entlang der Spannungsachse weniger stark auftritt, wenn im Bereitschaftsbetrieb und im ausgeschalteten Zustand der Speicheranordnung beide Elektroden der ferroelektrischen Speicherkondensatoren niederohmig verbunden sind.

## Patentansprüche

1. Ferroelektrische Speicheranordnung mit einem Speicherzellenfeld aus einer Vielzahl von Speicherzellen, die jeweils wenigstens einen Auswahltransistor, einen Kurzschlußtransistor (SG1, SG2) und einen Speicherkondensator (CF1, CF2) aufweisen und über Wortleitungen (WLi) und über Bitleitungen (BL, bBL) ansteuerbar sind, wobei jeder Kurzschlußtransistor mit seiner steuerbaren Strecke zwischen den Elektroden des zugehörigen Speicherkondensators (CF1, CF2) angeordnet ist,
**dadurch gekennzeichnet, daß**
- die Kurzschlußtransistoren (SG) eine andere Einsatzspannung als die Auswahltransistoren (TG) haben und
- Steueranschlüsse der Auswahltransistoren (TG) und Steueranschlüsse der Kurzschlußtransistoren (SG) mit den Wortleitungen (WLi) verbunden sind.

2. Ferroelektrische Speicheranordnung nach Anspruch 1,
**dadurch gekennzeichnet, daß** die Auswahltransistoren (TG) und die Kurzschlußtransistoren (SG) abwechselnd an die als Wort- und Steuerleitung dienende Leitung (z.B. WL2, WL3) angeschlossen sind.

3. Ferroelektrische Speicheranordnung nach Anspruch 1 oder 2,
**dadurch gekennzeichnet, daß** die Kurzschlußtransistoren (SG, SG1, SG2) aus Feldeffekttransistoren vom Verarmungstyp gebildet sind.

4. Ferroelektrische Speicheranordnung nach einem der Ansprüche 1 bis 3,
**dadurch gekennzeichnet, daß** der Speicherkondensator (CF) als Stapelkondensator oberhalb des Auswahltransistors (TG) oder als Offset-Kondensator neben dem Auswahltransistor (TG) angeordnet ist.

## Claims

1. Ferroelectric memory arrangement with a memory cell array consisting of a plurality of memory cells, each of which has at least one selection transistor, one short-circuit transistor (SG1, SG2) and one storage capacitor (CF1, CF2) and which can be controlled by means of word lines (WLi) and bit lines (BL, bBL), each short-circuit transistor being arranged with its controllable path between the electrodes of the associated storage capacitor (CF1, CF2), **characterized in that**
- the short-circuit transistors (SG) have a different threshold voltage from the selection transistors (TG) and
- control connections of the selection transistors (TG) and control connections of the short-circuit transistors (SG) are connected to the word lines (WLi).

2. Ferroelectric memory arrangement according to Claim 1, **characterized in that** the selection transistors (TG) and the short-circuit transistors (SG) are connected alternately to the conductor serving as word and control line (e.g. WL2, WL3).

3. Ferroelectric memory arrangement according to Claim 1 or 2, **characterized in that** the short-circuit transistors (SG, SG1, SG2) are formed by field effect transistors of the depletion type.

4. Ferroelectric memory arrangement according to one of Claims 1 to 3, **characterized in that** the storage capacitor (CF) is arranged as a stacked capacitor above the selection transistor (TG) or as an offset capacitor alongside the selection transistor (TG).

## Revendications

1. Dispositif de mémoire ferroélectrique comprenant un champ de cellules de mémoire, constitué d'une pluralité de cellules de mémoire, qui ont respectivement au moins un transistor de sélection, un transistor (SG1, SG2) de court-circuit et un condensateur (CF1, CF2) de mémoire et qui peuvent être commandés par des lignes (WLi) de mot et par des lignes (BL, bBL) de bit, chaque transistor de court-circuit étant disposé, par sa section qui peut être commandée, entre les électrodes du condensateur (CF1, CF2) de mémoire associée,
**caractérisé en ce que**,
- les transistors (SG) de court-circuit ont une tension de coupure autre que celle des transistors (TG) de sélection et,
- des bornes de commande des transistors (TG) de sélection et des bornes de commande des transistors (SG) de court-circuit sont reliées aux lignes (WLi) de mot.

2. Dispositif de mémoire ferroélectrique suivant la revendication 1, **caractérisé en ce que** les transistors (TG) de sélection et les transistors (SG) de court-circuit sont raccordés en alternance à la ligne (par exemple WL2, WL3) servant de ligne de mot et de ligne de commande.

3. Dispositif de mémoire ferroélectrique suivant la revendication 1 ou 2, **caractérisé en ce que** les transistors (SG, SG1, SG2) de court-circuit sont formés de transistors à effet de champ du type à appauvrissement.

4. Dispositif de mémoire ferroélectrique suivant l'une des revendications 1 à 3, **caractérisé en ce que** le condensateur (CF) de mémoire est disposé en tant que condensateur multicouche au-dessus de transistor (TG) de sélection ou en tant que condensateur Offset à côté du transistor (TG) de sélection.
